# FASCICULE DE BREVET EUROPEEN

(11) **EP 3 252 805 B1**
(45) Date de publication et mention de la délivrance du brevet: **02.01.2019**
(21) Numéro de dépôt: 17173920.4
(22) Date de dépôt: 01.06.2017
(51) Int. Cl.: H01L 21/683

(54) **PROCEDE DE FABRICATION D'UN DISPOSITIF DE MANIPULATION ET PROCEDE DE COLLAGE REVERSIBLE UTILISANT UN TEL DISPOSITIF**
HERSTELLUNGSVERFAHREN EINER HANDHABUNGSVORRICHTUNG, UND REVERSIBLES KLEBEVERFAHREN, BEI DEM EINE SOLCHE VORRICHTUNG VERWENDET WIRD
METHOD FOR MANUFACTURING A HANDLING DEVICE AND REVERSIBLE BONDING METHOD USING SUCH A DEVICE

(30) Priorité: 03.06.2016 FR 1655076
(43) Date de publication de la demande: 06.12.2017
(73) Titulaire: Commissariat à l'Energie Atomique et aux Energies Alternatives, 75015 Paris (FR)
(72) Inventeur: MONTMEAT, Pierre, 38190 FROGES (FR); FOURNEL, Frank, 38190 VILLARD-BONNOT (FR)
(74) Mandataire: Cabinet Camus Lebkiri

(56) Documents cités:
- US-A1- 2014 057 450
- US-A1- 2015 194 331

## Description

### DOMAINE TECHNIQUE DE L'INVENTION

Le domaine technique de l'invention est celui de la fabrication de dispositifs semiconducteurs. La présente invention concerne la fabrication d'un dispositif de manipulation ainsi qu'un procédé de collage réversible utilisant ledit dispositif de manipulation.

### ARRIERE-PLAN TECHNOLOGIQUE DE L'INVENTION

Il est connu lorsque l'on souhaite effectuer une étape de fabrication sur une galette (ou *wafer* en anglais), dans la suite appelée galette d'intérêt, de coller cette galette d'intérêt sur un dispositif de manipulation, ce dernier étant le plus souvent composé par une galette support comportant une couche d'adhésif composée d'une ou plusieurs couches de polymères. La galette d'intérêt peut par exemple être composée d'un matériau semi-conducteur tel que le silicium. Il peut notamment s'agir d'une galette de silicium amincie, par exemple une galette dont l'épaisseur est inférieure à 200 µm. Le dispositif de manipulation a pour rôle de renforcer la structure mécanique de la galette d'intérêt afin d'éviter la formation de fissures lors de la ou des étapes de fabrication suivant l'étape de collage. La couche d'adhésif, en plus d'assurer l'adhérence de la galette d'intérêt au dispositif de manipulation, permet de prendre en charge la topologie de la galette d'intérêt au niveau de la face en contact avec le dispositif de manipulation. L'épaisseur de cette couche d'adhésif est en général supérieure à 10 µm.

Une fois les étapes de fabrication nécessitant l'usage d'un dispositif de manipulation effectuées, le dispositif de manipulation et la galette d'intérêt sont séparés. Cependant, des résidus issus du ou des polymères composant la couche d'adhésif se retrouvent sur la galette d'intérêt ainsi que sur le dispositif de manipulation. Il faut donc procéder à une étape de nettoyage de la galette d'intérêt ainsi qu'à une étape de recyclage du dispositif de manipulation. L'étape de recyclage est en général effectuée en deux temps : une sous-étape de nettoyage de la surface de la galette support ; et une ou plusieurs sous-étapes d'enduction de sorte à former une nouvelle couche d'adhésif sur la galette support afin d'obtenir un nouveau dispositif de manipulation.

Afin de supprimer l'étape de recyclage, il peut être fait usage d'un procédé de collage réversible, c'est-à-dire un procédé de collage qui, après séparation, ne laisse aucune trace d'adhésif sur la galette d'intérêt et permet d'utiliser directement le dispositif de manipulation dans un nouveau procédé de collage en s'affranchissant donc de l'étape de recyclage. Cependant, une couche unique d'adhésif comportant une unique couche de polymère ne peut pas de manière générale être employée dans un procédé de collage réversible et ce, même si l'adhérence est faible au niveau des interfaces formées entre la couche d'adhésif et la galette d'intérêt ou la galette support. En effet, lorsque le collage est effectué à l'aide d'une couche d'adhésif comportant une unique couche de polymère, il est difficile d'assurer une différence d'adhérence suffisante entre les interfaces formées entre la couche d'adhésif et la galette d'intérêt ou la galette support pour pouvoir assurer le démontage. Afin d'introduire une différence dans l'énergie d'adhérence au niveau de ces interfaces, il est donc habituellement fait usage d'une couche d'adhésif comportant un empilement de différents polymères.

Afin de rendre possible l'utilisation d'un dispositif de manipulation comportant une couche unique d'adhésif composée d'une unique couche de polymère dans un procédé de collage réversible, il a été proposé d'utiliser une première température pour l'étape d'enduction sur la galette support de la couche d'adhésif comportant une unique couche de polymère et une deuxième température pour l'étape de collage de la galette d'intérêt sur le dispositif de manipulation. Pour cela, l'enduction de la couche d'adhésif est effectuée à une première température T₁ et l'étape de collage de galette d'intérêt sur le dispositif de manipulation est effectuée à une température T₂ telle que T₁ > T₂. En procédant de la sorte, l'énergie d'adhérence entre la couche d'adhésif et la galette support est plus importante qu'entre la couche d'adhésif et la galette d'intérêt. Ainsi, lors de la séparation, la couche d'adhésif demeure entièrement sur la galette support et aucune étape de nettoyage de la galette d'intérêt ou de recyclage du dispositif de manipulation n'est nécessaire. Le dispositif de manipulation peut alors être directement réutilisé et le procédé de collage est donc un procédé de collage réversible.

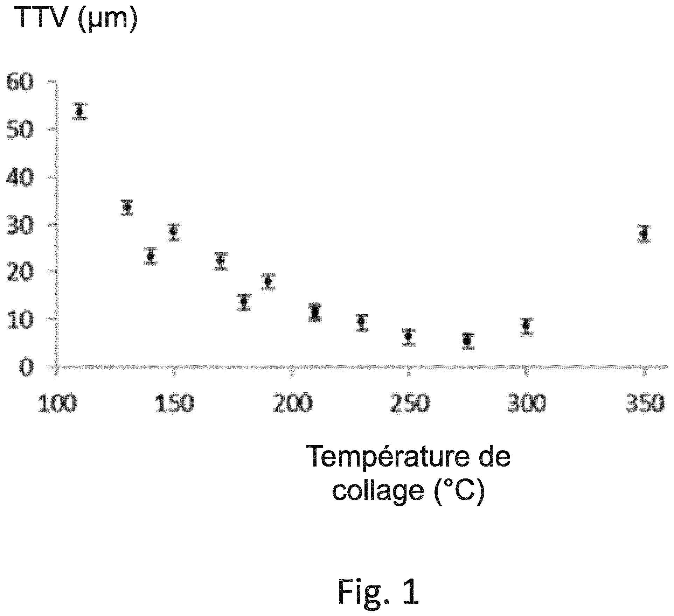

Cependant, lorsque l'étape de collage du dispositif de manipulation avec la galette d'intérêt est effectuée à des températures peu élevées, typiquement entre 100 et 160°C voire de l'ambiante à 160°C, la variation d'épaisseur totale (ou TTV en anglais pour Total Thickness Variation) de la couche d'adhésif devient importante et provoque une détérioration des étapes de fabrication nécessitant l'usage d'un dispositif de manipulation. La figure 1 illustre la variation d'épaisseur totale d'une couche unique d'adhésif composée de l'adhésif 5150 de la société Brewer pour différentes températures de collage. Cette courbe fait clairement apparaitre l'augmentation de la variation d'épaisseur totale de la couche unique d'adhésif, et donc la diminution de la qualité de collage pour les températures de collage faibles, notamment inférieures à 200 °C.

Afin de réduire la variation d'épaisseur totale de la couche unique d'adhésif tout en maintenant une température de collage basse, il est connu d'utiliser un adhésif composé d'un polymère dont la température de transition vitreuse est faible ce qui permet de diminuer la viscosité de la couche d'adhésif lors du collage et donc d'obtenir une plus faible variation d'épaisseur totale de cette même couche pour une température donnée. Cependant, lorsque les étapes qui succèdent l'étape de collage nécessitent l'usage d'une température élevée et notamment plus élevée que la température de collage, la couche d'adhésif sera, pour ces températures, très peu visqueuse. Cette faible viscosité de la couche d'adhésif pourra entrainer des délaminations et rendre l'usage d'un dispositif de manipulation incompatible avec certains procédés de fabrication.

On comprend donc de ce qui précède que, s'il est possible de réaliser un procédé de collage réversible à l'aide d'un dispositif de manipulation à couche unique d'adhésif, il est actuellement très difficile d'obtenir une variation d'épaisseur totale faible pour des températures de collage typiquement entre 100 et 160°C voire de l'ambiante à 160°C sans avoir recours à un polymère ayant une température de transition vitreuse faible et donc susceptible d'entrainer une délamination lors des étapes ultérieures réalisées à plus fortes températures.
Il existe donc un besoin d'un procédé permettant d'obtenir un dispositif de manipulation à couche unique d'adhésif permettant d'obtenir une variation d'épaisseur totale faible pour des températures de collage faible sans pour autant avoir recours à un polymère ayant une température de transition vitreuse faible.

Les deux documents US 2014/0057450 A1 et US 2015/0194331 A1 divulguent un procédé de collage réversible comprenant les caractéristiques du préambule de la revendication 1.

### RESUME DE L'INVENTION

L'invention offre une solution aux problèmes évoqués précédemment. Pour cela, cette dernière propose tout d'abord un procédé de fabrication dans lequel une première galette comportant une couche unique d'adhésif est mise en contact avec une deuxième galette comprenant une couche d'antiadhésif. Cette mise en contact permet d'obtenir un dispositif de manipulation comprenant une couche unique d'adhésif comportant une unique couche de polymère ayant une faible variation d'épaisseur totale pour des températures de collage faibles sans pour autant nécessiter que le polymère de la couche d'adhésif possède une température de transition vitreuse faible.

Par définition, on parle d'adhésif en présence d'un ou plusieurs polymères qui permettent lorsqu'ils sont disposés entre deux surfaces d'augmenter l'énergie d'adhérence entre ces deux surfaces par rapport à l'énergie qui existerait en son absence. Au contraire un antiadhésif diminue cette énergie d'adhérence.

En outre, le dispositif de manipulation obtenu permet de mettre en oeuvre un procédé de collage réversible d'une galette d'intérêt à un dispositif de manipulation selon l'invention ne nécessitant pas d'étape de nettoyage de la galette d'intérêt ou de recyclage du dispositif de manipulation à l'issue de l'étape de séparation.

Pour cela, l'invention concerne un procédé de fabrication d'un dispositif de manipulation selon la revendication 1. Le procédé comporte :
- une étape de dépôt d'une couche unique d'un adhésif sur une première surface d'une première galette ;
- une étape de dépôt d'une couche d'antiadhésif sur une première surface d'une deuxième galette différente de la première galette ;
- une étape de mise en contact de la première galette et de la deuxième galette, la mise en contact se faisant au niveau de la couche unique d'adhésif de la première galette et la couche d'antiadhésif de la deuxième galette ;
- une étape de séparation de la première galette et de la deuxième galette.

L'étape de mise en contact de la première galette et de la deuxième galette est effectuée à une température T_{C} telle que T_{C} > T_{g} + 100 °C, où T_{g} est la température de transition vitreuse du matériau composant la couche unique d'adhésif de la première galette. A l'issue de ce procédé, la première galette comprenant la couche unique d'adhésif forme un dispositif de manipulation.

La température T_{c} peut être par exemple T_{g} + 120°C.

Grace au procédé selon l'invention, on obtient un dispositif de manipulation comportant une couche unique d'adhésif ayant une faible variation d'épaisseur totale, y compris pour des températures de collage faible de l'ordre de 150°C, voire inférieures. En effet, la température lors de l'étape de mise en contact est choisie de sorte que la viscosité de l'adhésif est suffisante pour obtenir une bonne homogénéité de la couche unique d'adhésif et donc une variation d'épaisseur totale faible, de l'ordre de 10 µm pour une galette de 300 mm de diamètre. On entend par « une couche unique d'adhésif » une couche d'adhésif comportant une unique couche d'un polymère. De même, on entend par dispositif de manipulation le dispositif comprenant la première galette et la couche unique d'adhésif à l'issue de l'étape de séparation. En outre, on entend par « l'étape de mise en contact de la première galette et de la deuxième galette est effectuée à une température T_{C} » que lorsque la première galette entre en contact avec la deuxième galette, la température desdites galettes est égale à T_{c}.
Outre les caractéristiques qui viennent d'être évoquées dans le paragraphe précédent, le procédé de fabrication d'un dispositif de manipulation peut présenter une ou plusieurs caractéristiques complémentaires parmi les suivantes, considérées individuellement ou selon toutes les combinaisons techniquement possibles.
Avantageusement, l'étape de dépôt de la couche unique d'un adhésif comporte après une étape de dépôt proprement dite une étape de recuit de la première galette. Ce recuit permet d'éliminer le cas échéant le solvant de la couche unique d'adhésif et renforce l'adhérence entre la galette et l'adhésif.
Avantageusement, la température T_{c} lors de l'étape de mise en contact est supérieure à 160 °C, de préférence supérieure à 200 °C.

De préférence, l'antiadhésif composant la couche d'antiadhésif de la deuxième galette est choisi de sorte que l'énergie d'adhérence entre ladite couche d'antiadhésif et l'adhésif soit inférieure à 1 J.m⁻² à la température à laquelle est effectuée l'étape de mise en contact de la première galette et de la deuxième galette. Cette énergie est bien inférieure à l'adhérence généralement obtenue entre une galette et un adhésif qui dépasse souvent 4 J.m⁻² pour des températures de collages identiques.
Les valeurs d'adhérence fournies dans ce document sont classiquement mesurée par la méthode dite du double cantilever (Double Cantilever Beam test) encore appelée mesure d'adhérence par insertion de coin. On pourra se référer à l'article S. M. WIEDERHORN et al. JOURNAL OF APPLIED PHYSICS VOLUME 39, NUMBER 3 15 FEBRUARY 1968 pour plus de détail sur cette technique.

Ainsi, la séparation entre la première galette et la deuxième galette est facilitée tout en garantissant une bonne homogénéité de la couche unique d'adhésif.

Le dispositif de manipulation fabriqué selon le procédé de la présente invention peut être mis en oeuvre dans un procédé de collage réversible comprenant une étape de mise en contact dudit dispositif de manipulation avec une troisième galette, dite galette d'intérêt, la mise en contact dudit dispositif de manipulation avec ladite galette d'intérêt se faisant au niveau de la surface comprenant la couche unique d'adhésif.
Ainsi, des étapes de procédé supplémentaires peuvent être appliquées à la galette d'intérêt sans risque d'endommager cette dernière. En outre, l'épaisseur de la couche unique d'adhésif permet de prendre en charge de manière efficace la topologie de la galette d'intérêt au niveau de la surface sur laquelle la mise en contact est effectuée, y compris lorsque la température lors de l'étape de mise en contact est faible, typiquement inférieure à 160 °C, par exemple entre 100 et 160°C voire de l'ambiante à 160°C.
De plus, l'énergie d'adhérence entre la couche unique d'adhésif et la galette d'intérêt est plus faible que l'énergie d'adhérence entre la couche unique d'adhésif et la galette du dispositif de manipulation. Après séparation, la galette d'intérêt ne présente donc pas de trace d'adhésif et aucune étape de nettoyage n'est nécessaire. La couche unique d'adhésif du dispositif de manipulation conserve en outre une faible variation d'épaisseur totale et est donc directement réutilisable pour un autre procédé de collage réversible.
Outre les caractéristiques évoquées dans le paragraphe précédent, le procédé de collage réversible peut présenter une ou plusieurs caractéristiques complémentaires parmi les suivantes, considérées individuellement ou selon toutes les combinaisons techniquement possibles.

Avantageusement, l'étape de mise en contact du dispositif de manipulation avec la galette d'intérêt est réalisée à une température T_{CW} telle que T_{g} < T_{CW} < T_{g} + 50°C, où T_{g} est la température de transition vitreuse du matériau composant la couche unique d'adhésif du dispositif de manipulation.

Avantageusement, la température T_{CW} lors de l'étape de mise en contact du dispositif de manipulation avec la galette d'intérêt est inférieure à 160 °C.

La différence des deux procédés de mise en contact fait que l'adhérence entre la couche unique d'adhésif et la galette d'intérêt est plus faible que l'adhérence entre la couche unique et la galette de manipulation. Cela permet de faciliter l'étape de séparation.

Avantageusement, l'étape de mise en contact est précédée d'une étape de dépôt d'une couche d'antiadhésif sur une première surface de la galette d'intérêt ; la mise en contact lors de l'étape de mise en contact se faisant au niveau de la couche unique d'adhésif du dispositif de manipulation et la couche d'antiadhésif de la galette d'intérêt.

Ainsi, l'énergie d'adhérence peut être modulée par le choix de l'antiadhésif et les contraintes imposées lors de l'étape de séparation adaptées en fonction de la nature et la fragilité de la galette d'intérêt.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une courbe représentant la variation d'épaisseur totale (TTV) pour différentes températures de collage dans le cas d'un procédé selon l'état de l'art antérieur.
- La figure 2 montre un ordinogramme d'un procédé de fabrication d'un dispositif de manipulation selon un premier mode de réalisation de l'invention.
- Les figures 3A à 3E illustrent les différentes étapes d'un procédé de fabrication d'un dispositif de manipulation selon le premier mode de réalisation de l'invention.
- La figure 4 montre une courbe représentant l'épaisseur de la couche unique d'adhésif en fonction de la distance depuis le bord de la première galette.
- La figure 5 montre un ordinogramme d'un procédé de collage réversible selon un premier exemple.
- Les figures 6A et 6B illustrent les différentes étapes d'un procédé de collage réversible.
- La figure 7 montre un ordinogramme d'un procédé de collage réversible selon un deuxième exemple.
- Les figures 8A à 8C illustrent les différentes étapes d'un procédé de collage réversible.

### DESCRIPTION DETAILLEE D'AU MOINS UN MODE DE REALISATION DE L'INVENTION

Sauf précision contraire, un même élément apparaissant sur des figures différentes présente une référence unique.

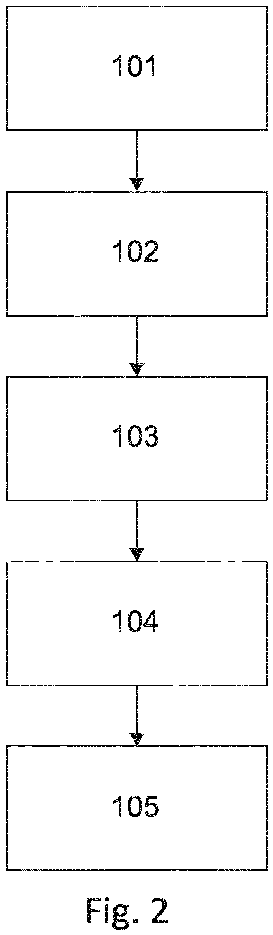

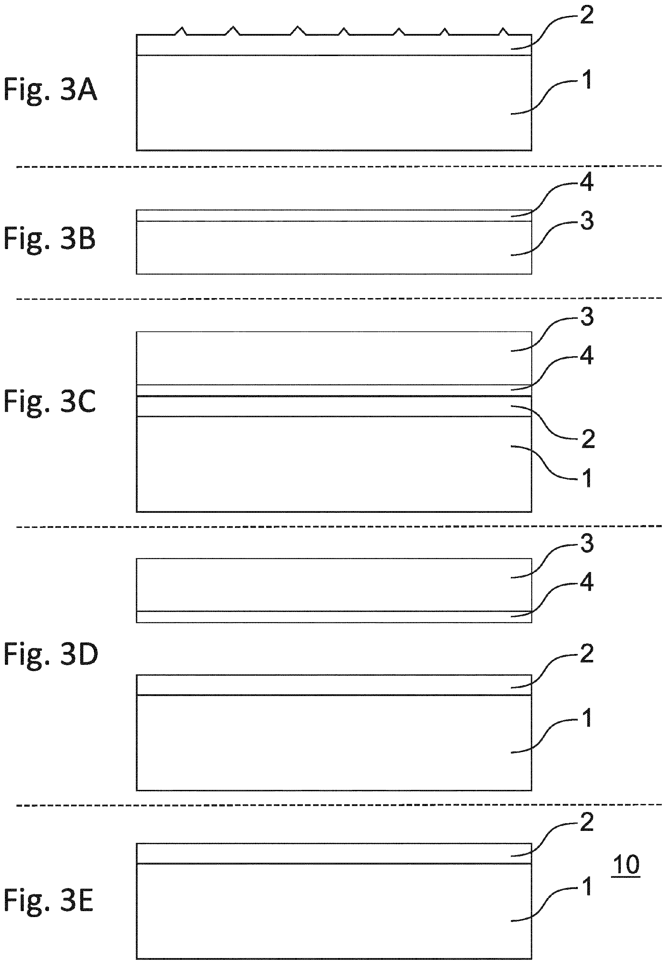

La figure 2 et les figures 3A à 3E illustrent un procédé de fabrication d'un dispositif de manipulation 10 selon un mode de réalisation, le procédé comportant :
- une étape de dépôt 101 (figure 2A) d'une couche unique d'adhésif 2 comprenant un solvant sur une première surface d'une première galette 1 ;
- une étape de recuit 102 de la première galette 1 de sorte à éliminer le solvant de la couche unique d'adhésif 2 ;
- une étape de dépôt 103 (figure 2B) d'une couche d'antiadhésif 4 sur une première surface d'une deuxième galette 3 différente de la première galette 1 ;
- une étape de mise en contact 104 (figure 2C) de la première galette 1 et de la deuxième galette 3, la mise en contact se faisant par la couche unique d'adhésif 2 de la première galette 1 et la couche d'antiadhésif 4 de la deuxième galette 3 ;
- une étape de séparation 105 (figure 2D) de la première galette 1 et de la deuxième galette 3.

Dans un mode de réalisation, l'étape 105 de séparation a lieu immédiatement après l'étape 104 de mise en contact, c'est-à-dire sans qu'aucune étape technologique (lithographie, polissage mécanochimique, etc.) n'ait lieu entre l'étape 104 de mise en contact et l'étape 105 de séparation.

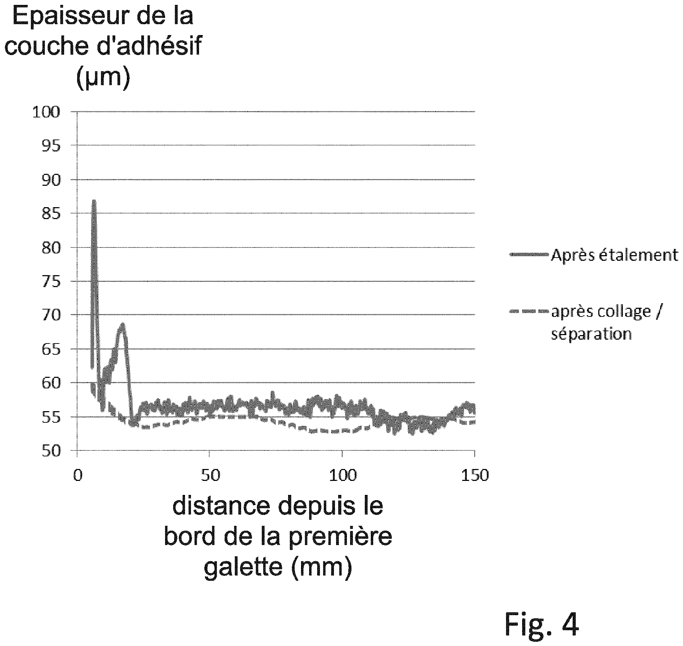

Dans un mode de réalisation, l'étape de dépôt 101 de la couche unique d'adhésif 2 est effectuée par une technique d'enduction centrifuge (ou *spin coating* en anglais) et l'épaisseur de la couche unique d'adhésif 2 est comprise entre 45 µm et 65 µm, par exemple égale à 55 µm. Le matériau utilisé pour réaliser la couche unique d'adhésif 2 peut être une colle de type BSI5150 vendue par la société Brewer qui possède une température de transition vitreuse comprise entre 80 et 100°C et permet d'obtenir une énergie d'adhérence entre ladite colle et la première galette supérieure à 5 J.m⁻². L'étape de recuit 102 est alors effectuée à une température de 220°C. Cette étape de recuit 102 permet notamment d'évaporer le solvant de la couche unique d'adhésif 2. Comme illustré à la figure 3A et à la figure 4 (courbe « après étalement »), la surface de la couche d'adhésif possède alors une variation d'épaisseur totale élevée de l'ordre de 35 µm.

Dans un mode de réalisation, l'étape de dépôt 103 d'une couche d'antiadhésif 4 sur une première surface d'une deuxième galette 3 est effectué par enduction centrifuge et l'épaisseur de la couche d'antiadhésif 4 est de l'ordre de 50 nm. Le matériau utilisé pour réaliser la couche d'antiadhésif 4 peut être un polymère fluoré de type Novec 2702 vendu par la société 3M.
Dans un mode de réalisation, l'étape de mise en contact 104 est effectuée à une température de 210 °C. A l'issue de cette étape de mise en contact 104, on sépare la première galette 1 de la deuxième galette 3. Comme illustré à la figure 3E et à la figure 4 (courbe « après collage/séparation »), à l'issue de cette étape de séparation 105, la première galette 1 possède alors une couche unique d'adhésif 2 dont la variation d'épaisseur totale est faible (7 µm) et bien meilleure que celle obtenue directement après son étalement (35µm). La première galette 1 comprenant une couche d'adhésif 2 ainsi obtenue forme alors un dispositif de manipulation 10.
Le dispositif de manipulation 10 obtenu à l'aide d'un procédé de fabrication selon un premier aspect de l'invention peut ensuite être mise en oeuvre dans un procédé de collage réversible.

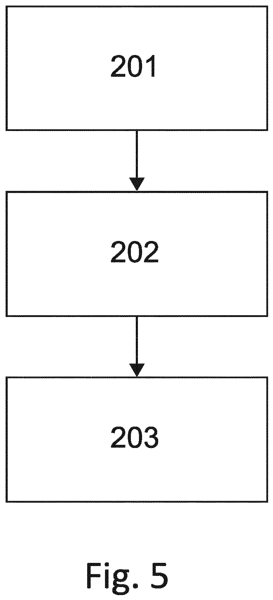

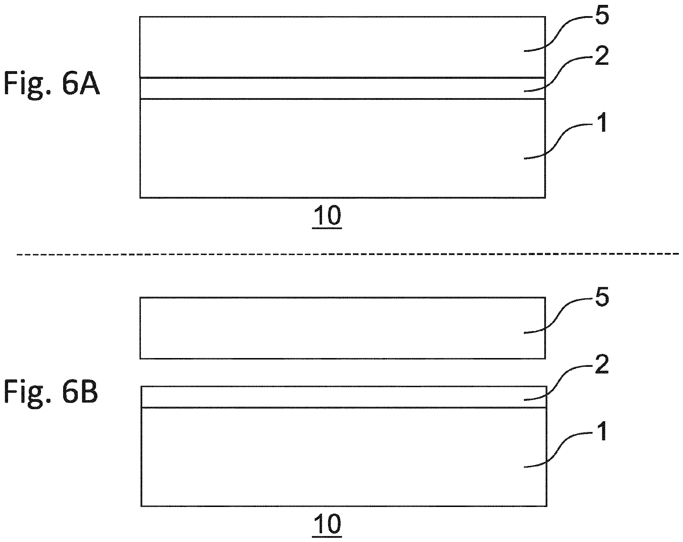

La figure 5 et les figures 6A et 6B illustrent un procédé de collage réversible mettant en oeuvre le dispositif de manipulation 10 obtenu par un procédé selon l'invention. Un tel procédé de collage est utilisé lorsque l'on souhaite réaliser une ou plusieurs étapes de fabrication sur une galette d'intérêt 5, par exemple une galette amincie, et que cette ou ces étapes de fabrication nécessitent un dispositif de manipulation 10 afin de prévenir tout dommage au niveau de la galette d'intérêt 5. Comme illustré à la figure 6A, dans le procédé de collage réversible selon l'invention, une galette d'intérêt 5 est mise en contact avec le dispositif de manipulation 10 au niveau de la surface comprenant la couche unique d'adhésif 2. Dans un mode de réalisation, cette étape de mise en contact 201 est effectuée à une température de 150°C. Dans cette configuration la variation d'épaisseur totale de la couche d'adhésif 2 est sensiblement égale à 7 µm pour une épaisseur de la couche unique d'adhésif 2 sensiblement égale à 55 µm. Cette TTV est bien meilleure que celle qu'on aurait obtenue au moyen d'une mise en contact à 150°C (sans utilisation du dispositif de manipulation 10) : 30 µm. Une fois la galette d'intérêt 5 en place sur le dispositif de manipulation 10, cette dernière peut subir de nouvelles étapes de fabrication 202.

Dans un mode de réalisation, les étapes de fabrication 202 suivant l'étape de collage réversible comprennent une étape d'amincissement et une étape de détourage. Pour cela, la galette d'intérêt 5 est amincie à l'aide d'une technique de ponçage (*grinding* en anglais) jusqu'à atteindre une épaisseur de 80 µm puis est détourée à l'aide d'une scie sur une largeur de 1.5 mm. Comme illustré à la figure 6B, la galette d'intérêt 5 ainsi obtenue est ensuite séparée mécaniquement du dispositif de manipulation 10 par traction afin d'obtenir un film fin de silicium sans écaillage ni fissure. L'étape de séparation mécanique 203 s'opère au niveau de l'interface couche unique d'adhésif/galette d'intérêt. Dans ce mode de réalisation, l'énergie d'adhérence à l'interface couche unique d'adhésif/galette d'intérêt est sensiblement égale à 0.9 J.m⁻². A l'issue de l'étape de séparation 203, la galette d'intérêt 5 présente une surface dont la variation d'épaisseur totale est de 7 µm et ne comporte aucune trace de polymère. La totalité de la couche unique adhésive 2 est donc toujours présente sur le dispositif de manipulation 10 et ce dernier peut donc être directement réutilisé. En outre, la galette d'intérêt 5 ne nécessite pas d'étape de nettoyage, aucun résidu d'adhésif ne se trouvant à sa surface. Le dispositif de manipulation 10 peut donc être utilisé immédiatement dans un nouveau procédé de collage réversible.

Dans un mode de réalisation alternatif, l'étape de mise en contact 201 est effectuée à une température de 110°C. Dans cette configuration également, la variation d'épaisseur totale de la couche unique d'adhésif 2 est sensiblement égale à 7 µm pour une épaisseur sensiblement égale à 55 µm. Cependant, l'énergie d'adhérence à l'interface couche unique d'adhésif/galette d'intérêt n'est plus que de 0.5 J.m⁻². Ce mode de réalisation permet de faciliter la séparation entre le dispositif de manipulation 10 et la galette d'intérêt 5 lors de l'étape de séparation 203.

Si les contraintes mécaniques lors des étapes de fabrication 202 réalisées sur la galette d'intérêt 5 sont importantes, il est préférable de choisir une énergie d'adhérence élevée au détriment de la facilité de séparation. Il est cependant préférable de maintenir la température de mise en contact 201 de la galette d'intérêt 5 avec le dispositif de manipulation 10 en dessous de la température utilisée durant le procédé de fabrication dudit dispositif de manipulation 10 lors de l'étape de mise en contact 104 de la couche unique d'adhésif 2 avec la couche d'antiadhésif 4.

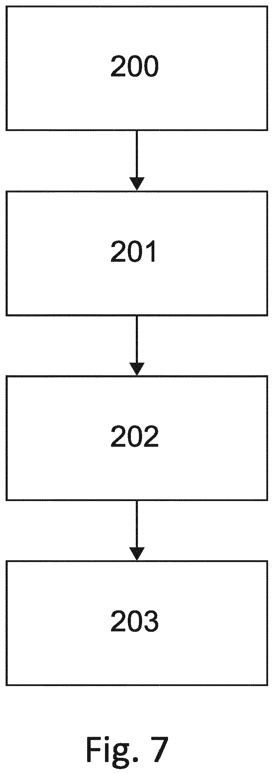

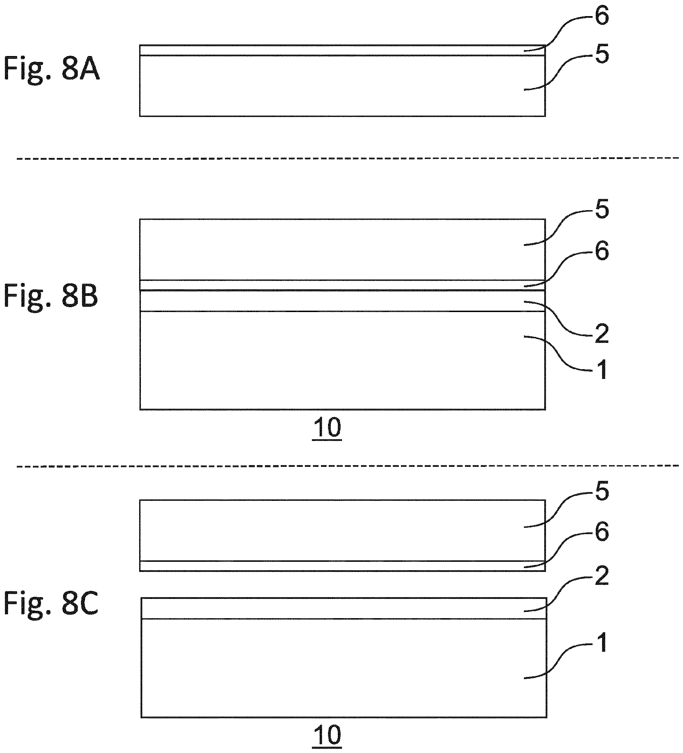

Dans un autre mode de réalisation illustré dans la figure 7 et les figures 8A à 8C, l'étape de mise en contact 201 est précédée d'une étape de dépôt 200 (figure 8A) d'une couche d'antiadhésif 6 sur une première surface de la galette d'intérêt 5. Dans ce mode de réalisation, la mise en contact 201 (figure 8B) se fait donc au niveau de la couche unique d'adhésif 2 du dispositif de manipulation 10 et de la couche d'antiadhésif 6 de la galette d'intérêt 5.

En utilisant une couche d'antiadhésif dans le procédé de collage selon un mode de réalisation de l'invention, la température lors de l'étape de mise en contact 201 de la galette d'intérêt 5 avec le dispositif de manipulation 10 peut être inférieure à la température utilisée durant le procédé de fabrication dudit dispositif de manipulation 10 lors de l'étape de mise en contact 104 de la couche unique d'adhésif 2 avec la couche d'antiadhésif 4.

Dans un mode de réalisation, l'étape de dépôt 200 de la couche d'antiadhésif 6 sur une première surface de la galette d'intérêt 5 est effectué par enduction centrifuge et l'épaisseur de la couche d'antiadhésif 6 est de 50 nm. Le matériau utilisé pour réaliser la couche d'antiadhésif 6 peut être un polymère fluoré de type Novec 2702 vendu par la société 3M. L'énergie d'adhérence entre la couche unique d'adhésif 2 du dispositif de manipulation 10 et la couche d'antiadhésif 6 de la galette d'intérêt 5 est de 0.4 J.m⁻², ce qui facilité la séparation de la galette d'intérêt 5 et du dispositif de manipulation 10.

La galette d'intérêt 5 peut ensuite subir une ou plusieurs étapes de fabrication 202 comme évoqué précédemment. Une fois cette ou ces étapes de fabrication 202 réalisées, la galette 5 d'intérêt et le dispositif de manipulation 10 sont séparés (figure 8C). Dans ce mode de réalisation également la totalité de la couche unique adhésive 2 est toujours présente sur le dispositif de manipulation 10 à l'issue de l'étape de séparation 203 et ce dernier peut donc être directement réutilisé. A l'issue de la séparation, la couche d'antiadhésif 6 est retirée de la galette d'intérêt 5. Ce retrait peut par exemple être effectué à l'aide d'un traitement par plasma oxygène à 80°C.

## Revendications

1. Procédé de fabrication d'un dispositif de manipulation (10) comportant :
- une étape de dépôt (101) d'une couche unique d'un adhésif (2) sur une première surface d'une première galette (1);
- une étape de dépôt (103) d'une couche d'antiadhésif (4) sur une première surface d'une deuxième galette (3) différente de la première galette (1) ;
- une étape de mise en contact (104) de la première galette (1) et de la deuxième galette (3), la mise en contact se faisant au niveau de la couche unique d'adhésif (1) de la première galette (2) et la couche d'antiadhésif (4) de la deuxième galette (3) ;
- une étape de séparation (105) de la première galette (1) et de la deuxième galette (3) ;
la première galette (1), à l'issue de l'étape de séparation, comprenant la couche unique (2) d'adhésif et formant un dispositif de manipulation (10), ledit procédé étant **caractérisé en ce que** l'étape de mise en contact (104) de la première galette (1) et de la deuxième galette (3) est effectuée à une température T_{C} telle que T_{C} > T_{g} + 100°C où T_{g} est la température de transition vitreuse du matériau composant la couche unique d'adhésif (2) de la première galette (1).

2. Procédé selon la revendication précédente **caractérisé en ce que** la température T_{c} lors de l'étape de mise en contact est supérieure à 160 °C, de préférence supérieure à 200 °C.

3. Procédé selon l'une des revendications précédentes **caractérisé en ce que** l'antiadhésif composant la couche d'antiadhésif (4) de la deuxième galette (3) est choisi de sorte que l'énergie d'adhérence de ladite couche d'antiadhésif (4) soit inférieure à 1J.m⁻² à la température à laquelle est effectuée l'étape de mise en contact (104) de la première galette (1) et de la deuxième galette (3).

4. Procédé de collage réversible **caractérisé en ce qu'**il comprend une étape de réalisation d'un dispositif de manipulation (10) à l'aide d'un procédé selon l'une des revendications précédentes et une étape de mise en contact (201) dudit dispositif de manipulation (10) avec une troisième galette, dite galette d'intérêt (5), la mise en contact dudit dispositif de manipulation (10) avec ladite galette d'intérêt (5) se faisant au niveau de la surface comprenant la couche unique d'adhésif (2).

5. Procédé de collage selon la revendication précédente **caractérisé en ce que** l'étape de mise en contact (201) du dispositif de manipulation (10) avec la galette d'intérêt (5) est réalisée à une température T_{CW} telle que T_{g} < T_{CW} < T_{g} + 50°C, où T_{g} est la température de transition vitreuse du matériau composant la couche unique d'adhésif (2) du dispositif de manipulation (10).

6. Procédé selon la revendication précédente **caractérisé en ce que** la température T_{CW} lors de l'étape de mise en contact (201) du dispositif de manipulation (10) avec la galette d'intérêt (5) est inférieure à 160 °C.

7. Procédé de collage selon l'une des deux revendications précédentes **caractérisé en ce que** l'étape de mise en contact (201) est précédée d'une étape de dépôt (200) d'une couche d'antiadhésif (6) sur une première surface de la galette d'intérêt (5) ; la mise en contact lors de l'étape de mise en contact (201) se faisant au niveau de la couche unique d'adhésif (2) du dispositif de manipulation (10) et la couche d'antiadhésif (6) de la galette d'intérêt (5).

## Patentansprüche

1. Herstellungsverfahren einer Handhabungsvorrichtung (10), umfassend:
- einen Aufbringungsschritt (101) einer einzigen Schicht eines Haftmittels (2) auf einer ersten Oberfläche eines ersten Wafers (1);
- einen Aufbringungsschritt (103) einer Anti-Haftschicht (4) auf einer ersten Oberfläche eines zweiten Wafers (3), der von dem ersten Wafer (1) unterschiedlich ist;
- einen Kontaktierungsschritt (104) des ersten Wafers (1) und des zweiten Wafers (3), wobei das Kontaktieren in Bezug auf die einzige Haftschicht (1) des ersten Wafers (2) und die Anti-Haftschicht (4) des zweiten Wafers (3) erfolgt;
- einen Trennschritt (150) des ersten Wafers (1) und des zweiten Wafers (3);
wobei der erste Wafer (1) nach Abschluss des Trennschritts die einzige Haftschicht (2) umfasst und eine Handhabungsvorrichtung (10) bildet, wobei das genannte Verfahren **dadurch gekennzeichnet ist, dass** der Kontaktierungsschritt (104) des ersten Wafers (1) und des zweiten Wafers (3) bei einer Temperatur T_{C}, mit T_{C} > T_{g} + 100° C durchgeführt wird, bei der T_{g} die Übergangstemperatur des Materials zum glasartigen Zustand ist, das die einzige Haftschicht (2) des ersten Wafers (1) bildet.

2. Verfahren gemäß dem voranstehenden Anspruch, **dadurch gekennzeichnet, dass** die Temperatur T_{C} bei dem Kontaktierungsschritt höher ist als 160°C, bevorzugt höher als 200° C.

3. Verfahren gemäß einem der voranstehenden Ansprüche, **dadurch gekennzeichnet, dass** das die Antihaftschicht (4) des zweiten Wafers bildende Antihaftmittel derart ausgewählt ist, dass die Adhärenzenergie der genannten Antihaftschicht (4) bei der Temperatur, bei der der Kontaktierungsschritt (104) des ersten Wafers (1) und des zweiten Wafers (3) durchgeführt wird, geringer ist als 1J.m⁻².

4. Reversibles Verklebungsverfahren, **dadurch gekennzeichnet, dass** es einen Realisierungsschritt einer Handhabungsvorrichtung (10) mithilfe eines Verfahrens gemäß irgendeinem der voranstehenden Ansprüche und einen Kontaktierungsschritt (201) der genannten Behandlungsvorrichtung (10) mit einem dritten Wafer, bezeichnet als Wafer von Interesse (5) umfasst, wobei die Kontaktierung der genannten Handhabungsvorrichtung (10) mit dem genannten Wafer von Interesse (5) in Bezug auf die Oberfläche erfolgt, die die einzige Haftschicht (2) umfasst.

5. Verklebungsverfahren gemäß dem voranstehenden Anspruch, **dadurch gekennzeichnet, dass** der Kontaktierungsschritt (201) der Handhabungsvorrichtung (10) mit dem Wafer (5) von Interesse (5) bei einer Temperatur T_{CW} realisiert wird, mit T_{g} < T_{CW} < T_{g} + 50° C, bei der T_{g} die Übergangstemperatur des Materials in den glasartigen Zustand ist, das die einzige Haftschicht (2) der Behandlungsvorrichtung (10) bildet.

6. Verfahren gemäß dem voranstehenden Verfahren, **dadurch gekennzeichnet, dass** die Temperatur Tcw bei dem Kontaktierungsschritt (201) der Handhabungsvorrichtung (10) mit dem Wafer von Interesse (5) niedriger ist als 160° C.

7. Verklebungsverfahren gemäß einem der zwei voranstehenden Ansprüche, **dadurch gekennzeichnet, dass** dem Kontaktierungsschritt (201) ein Aufbringungsschritt (200) einer Antihaftschicht (6) auf einer ersten Oberfläche des Wafers von Interesse (5) vorausgeht; wobei das Kontaktieren bei dem Kontaktierungsschritt (201) in Bezug auf die einzige Haftschicht (2) der Handhabungsvorrichtung (10) und die Antihaftschicht (6) des Wafers von Interesse (5) erfolgt.

## Claims

1. Method for manufacturing a handling device (10) comprising:
- a step of deposition (101) of a single layer of an adhesive (2) on a first surface of a first wafer (1);
- a step of deposition (103) of an antiadhesive layer (4) on a first surface of a second wafer (3) different from the first wafer (1);
- a step of bringing into contact (104) the first wafer (1) and the second wafer (3), the bringing into contact taking place at the level of the single adhesive layer (1) of the first wafer (2) and the antiadhesive layer (4) of the second wafer (3);
- a step of separation (105) of the first wafer (1) and the second wafer (3);
the first wafer (1), after the separation step, comprising the single adhesive layer (2) and forming a handling device (10), said method being **characterised in that** the step of bringing into contact (104) the first wafer (1) and the second wafer (3) is carried out at a temperature T_{C} such that T_{C} > T_{g} + 100°C where T_{g} is the glass transition temperature of the material composing the single adhesive layer (2) of the first wafer (1).

2. Method according to the preceding claim **characterised in that** the temperature T_{c} during the step of bringing into contact is greater than 160°C, preferably greater than 200°C.

3. Method according to one of the preceding claims **characterised in that** the antiadhesive composing the antiadhesive layer (4) of the second wafer (3) is chosen such that the adherence energy of said antiadhesive layer (4) is less than 1J.m⁻² at the temperature at which the step of bringing into contact (104) the first wafer (1) and the second wafer (3) is carried out.

4. Method for reversible bonding **characterised in that** it comprises a step of producing a handling device (10) by means of a method according to one of the preceding claims and a step of bringing into contact (201) said handling device (10) with a third wafer, designated wafer of interest (5), the bringing into contact of said handling device (10) with said wafer of interest (5) taking place at the level of the surface comprising the single adhesive layer (2).

5. Method for bonding according to the preceding claim **characterised in that** the step of bringing into contact (201) the handling device (10) with the wafer of interest (5) is carried out at a temperature T_{CW} such that T_{g} < T_{CW} < T_{g} + 50°C, where T_{g} is the glass transition temperature of the material composing the single adhesive layer (2) of the handling device (10).

6. Method according to the preceding claim **characterised in that** the temperature T_{CW} during the step of bringing into contact (201) the handling device (10) with the wafer of interest (5) is less than 160°C.

7. Method for bonding according to one of the two preceding claims **characterised in that** the step of bringing into contact (201) is preceded by a step of deposition (200) of an antiadhesive layer (6) on a first surface of the wafer of interest (5); the bringing into contact during the step of bringing into contact (201) taking place at the level of the single adhesive layer (2) of the handling device (10) and the antiadhesive layer (6) of the wafer of interest (5).
